# EUROPEAN PATENT APPLICATION

(11) **EP 4 410 923 A1**
(43) Date of publication of application: **07.08.2024**
(21) Application number: 22876252.2
(22) Date of filing: 27.09.2022
(51) Int. Cl.: C09K 3/14, B24B 37/00, C09G 1/02, C09G 1/04, H01L 21/304

(54) **POLISHING COMPOSITION**

(30) Priority: 30.09.2021 JP 2021162177
(71) Applicant: Fujimi Incorporated, Kiyosu-shi, Aichi 452-8502 (JP)
(72) Inventor: MORI, Yoshio, Kiyosu-shi, Aichi 452-8502 (JP); NAKAGAI, Yuichiro, Kiyosu-shi, Aichi 452-8502 (JP); ODA, Hiroyuki, Kiyosu-shi, Aichi 452-8502 (JP)
(74) Representative: Grünecker Patent- und Rechtsanwälte PartG mbB
(86) International application number: PCT/JP2022/035995
(87) International publication number: WO 2023/054386

(57) **Abstract**

Provided is a polishing composition that can improve the surface quality of a surface to be polished after polishing while achieving an excellent polishing removal rate for an object to be polished. The polishing composition to be provided contains sodium permanganate as an oxidant. The polishing composition contains or does not contain an abrasive A with a Mohs hardness of less than 8 is contained as an abrasive. The polishing composition can also be preferably used to polish an object to be polished formed of a high hardness material having a Vickers hardness of 1500 Hv or more.

## Description

### [Technical Field]

The present invention relates to a polishing composition. The application claims the priority based on Japanese Patent Application No. 2021-162177, filed on September 30, 2021, the content of which is herein incorporated by reference in its entirety.

### [Background Art]

A surface of a material such as metal, semimetal, non-metal, or an oxide thereof has been polished with a polishing composition. For example, a surface made of a compound semiconductor material such as silicon carbide, boron carbide, tungsten carbide, silicon nitride, titanium nitride, or gallium nitride is processed by polishing (lapping), which is performed by supplying a diamond abrasive between the surface and a polishing platen. However, the lapping with the diamond abrasive is prone to generate defects and strains due to generated or remaining scratches or dents, or the like. For this reason, exploration has been made for polishing with a polishing pad and a polishing composition, after the lapping with the diamond abrasive or instead of such lapping. Examples of literatures disclosing this kind of conventional technique include Patent Literature 1.

### [Citation List]

### [Patent Literature]

[Patent Literature 1] WO2016-072370

### [Summary of Invention]

### [Technical Problem]

Generally, a polishing removal rate is required to be practically, sufficiently high from the viewpoints of manufacturing efficiency and cost-effectiveness. For example, polishing of a surface made of a high hardness material such as silicon carbide has strongly required an improved polishing removal rate. In one idea for improving the polishing removal rate in the polishing of various objects to be polished, including a substrate made of such a high hardness material, it is considered to use a polishing composition containing an abrasive with high hardness, such as alumina. The abrasive with high hardness, however, tends to generate a scratch or a dent on a surface to be polished, and it has been uneasy to improve the surface quality of the surface to be polished with the polishing composition containing such an abrasive.

As another means for improving the polishing removal rate, it is considered to use a polishing composition containing, as a polishing accelerator, a component that has an effect of chemically modifying the surface to be polished to make the surface fragile. For example, Patent Literature 1 suggests a polishing composition containing an abrasive, water, and an oxidant such as potassium permanganate and used for polishing a substrate made of a high hardness material. However, the oxidant such as potassium permanganate conventionally used in this field does not easily dissolve in water and there has been a limitation in increasing the content of the oxidant in the polishing composition. Thus, there has been a certain limitation in improving the polishing removal rate by the use of the conventional oxidant.

The present invention has been made in view of such circumstances, and it is an object to provide a polishing composition that can improve the surface quality of a surface to be polished after polishing while achieving an excellent polishing removal rate for an object to be polished.

### [Solution to Problem]

A polishing composition provided in the present specification contains sodium permanganate as an oxidant. Sodium permanganate tends to have higher solubility than other oxidants that have been used in this field conventionally. Therefore, in the polishing composition containing sodium permanganate as the oxidant, the content of the oxidant can be suitably increased easily and therefore, the polishing removal rate improves easily. Moreover, the polishing composition disclosed herein contains an abrasive A with a Mohs hardness of less than 8 as an abrasive, or does not contain the abrasive. By the polishing composition containing the abrasive A with a Mohs hardness of less than 8, which is relatively soft, or the polishing composition not containing the abrasive, the generation of a scratch or a dent on a surface to be polished is likely to be suppressed. Therefore, with the constitution containing sodium permanganate as the oxidant, and containing the abrasive A with a Mohs hardness of less than 8 as the abrasive or not containing the abrasive, both the polishing removal rate and the surface quality of the surface to be polished can be improved.

In some embodiments in which the polishing composition contains the abrasive A, the content of the abrasive A in the polishing composition is less than 10 wt%. In the art disclosed herein, even the polishing composition containing a relatively small amount of abrasive A can achieve the excellent polishing removal rate; therefore, the polishing composition in which the content of the abrasive A is as described above can improve both the polishing removal rate and the surface quality of the surface to be polished.

In some embodiments in which the polishing composition contains the abrasive A, the polishing composition contains a silica abrasive as the abrasive A. Using the silica abrasive as the abrasive A can further improve both the polishing removal rate and the surface quality of the surface to be polished.

In some embodiments, the polishing composition contains a first metal salt selected from alkaline earth metal salts. Using such a first metal salt tends to improve the polishing removal rate. In some preferred embodiments, the first metal salt is a nitrate.

In some embodiments, the polishing composition contains a second metal salt selected from salts of cations containing metals that belong to Groups 3 to 16 in the periodic table, and anions. Using such a second metal salt tends to improve the polishing removal rate. In some preferred embodiments, the second metal salt is an aluminum salt. In some preferred embodiments, the first metal salt and the second metal salt can be used in combination.

In some embodiments, the polishing composition has a pH of 1.0 or more and less than 6.0. In such a pH range, the polishing composition disclosed herein easily exhibits the high polishing removal rate.

The polishing composition disclosed herein is used for polishing a material having a Vickers hardness of 1500 Hv or more, for example. In polishing of such a high hardness material, an effect caused by the art disclosed herein can be preferably exerted. An application effect of the present invention can be exerted more preferably. In some embodiments, the material having a Vickers hardness of 1500 Hv or more is non-oxide (i.e., a compound that is not an oxide). Polishing of an object to be polished that is a non-oxide is more likely to suitably exert an effect to improve the polishing removal rate by the polishing composition disclosed herein.

The polishing composition disclosed herein is used for polishing of silicon carbide, for example. In polishing of silicon carbide, an effect caused by the art disclosed herein can be preferably exerted.

This specification further provides a polishing method for an object to be polished. The polishing method includes a step of polishing an object to be polished using any of the polishing compositions disclosed herein. Such a polishing method can increase the polishing removal rate and additionally improve the quality of the surface to be polished, even in polishing an object to be polished that is formed of a high hardness material. This can improve productivity of an object derived via polishing with the polishing method (a polished object, for example, a compound semiconductor substrate such as a silicon carbide substrate).

### [Brief Description of Drawings]

Fig. 1 is a graph expressing a relation between a content of an oxidant (wt%) and a polishing removal rate (nm/h) for polishing compositions according to some embodiments.
Fig. 2 is a graph expressing a relation between a content of an oxidant (wt%) and a polishing removal rate (nm/h) for polishing compositions according to some other embodiments.

### [Description of Embodiments]

Preferred embodiments of the present invention will be described below. Matters that are other than matters particularly mentioned in the present specification and that are necessary for the implementation of the present invention can be grasped as design matters of those skilled in the art based on the prior art in the relevant field. The present invention can be implemented based on contents disclosed herein and common technical knowledge in the relevant field.

### <Polishing composition>

### (Oxidant)

The polishing composition disclosed herein contains an oxidant. The oxidant is effective to reduce the hardness of a material to be polished (for example, a non-oxide material with high hardness, such as silicon carbide) and make the material fragile. Therefore, the oxidant can exert an effect to improve the polishing removal rate in polishing of the material to be polished. In this specification, the oxidant does not contain a metal salt (contains neither a first metal salt nor a second metal salt) to be described below.

The polishing composition disclosed herein contains sodium permanganate as the oxidant. Sodium permanganate tends to have high solubility in water compared to other permanganates such as potassium pennanganate. Therefore, the constitution containing sodium permanganate as the oxidant tends to increase the content of the oxidant in the polishing composition suitably. Accordingly, using sodium permanganate as described above tends to improve the polishing removal rate.

The content of sodium permanganate in the polishing composition is not limited in particular, and can be set as appropriate in accordance with a purpose of use and an embodiment of use of the polishing composition. In some embodiments, the content of sodium permanganate is suitably about 0.5 wt% or more from the viewpoint of improving the polishing removal rate. From the viewpoint of improving the polishing removal rate, the content of sodium permanganate is preferably 1 wt% or more, more preferably 1.4 wt% or more, and still more preferably 2.7 wt% or more, and may be 4 wt% or more or 6 wt% or more. From the viewpoint of facilitating the achievement of the higher polishing removal rate by taking advantage of sodium permanganate having high solubility in water, in some embodiments, the content of sodium permanganate is preferably 6.5 wt% or more, more preferably 8 wt% or more, and still more preferably 9 wt% or more, and may be 10 wt% or more, 15 wt% or more, 20 wt% or more, or 22 wt% or more. In addition, in some embodiments, the content of sodium permanganate in the polishing composition is suitably about 45 wt% or less and preferably 40 wt% or less, more preferably 35 wt% or less, and still more preferably 30 wt% or less, and may be 25 wt% or less, 20 wt% or less, 15 wt% or less, or 10 wt% or less. It can be advantageous to reduce the content of sodium permanganate from the viewpoint of reducing the occurrence of defects due to sodium that remains after the polishing.

The polishing composition disclosed herein may or may not additionally contain other oxidant than sodium permanganate (such an oxidant is also referred to as "other oxidant" below). Specific examples of a compound to be a potential option of the other oxidant include: peroxide compounds such as hydrogen peroxide; permanganate compounds including permanganic acid and salts thereof other than sodium permanganate (for example, potassium permanganate); periodate compounds including periodic acid and salts thereof such as sodium periodate and potassium periodate; iodate compounds including iodic acid and salts thereof such as ammonium iodate; bromate compounds including bromic acid and salts thereof such as potassium bromate; ferrate compounds including ferric acid and salts thereof such as potassium ferrate; chromate compounds and dichromate compounds including perchromic acid, chromic acid, and salts thereof such as potassium chromate, and dichromic acid and salts thereof such as potassium dichromate; vanadate compounds including vanadic acid and salts thereof such as ammonium vanadate, sodium vanadate, and potassium vanadate; mthenate compounds including perruthenic acid and salts thereof, molybdate compounds including permolybdic acid, molybdic acid, and salts thereof such as ammonium molybdate and disodium molybdate; rhenate compounds including perrhenic acid and salts thereof; tungstate compounds including pertungstic acid, tungstic acid, and salts thereof such as disodium tungstate; persulfate compounds including persulfuric acids such as peroxomonosulfuric acid and peroxodisulfuric acid, and salts thereof such as ammonium persulfate and potassium persulfate; chlorate compounds and perchlorate compounds including chloric acid and salts thereof, and perchloric acid and salts thereof such as potassium perchlorate; osmate compounds including perosmic acid and osmic acid; selenate compounds including perselenic acid and selenic acid; and ceric ammonium nitrate. As the other oxidant, one kind of such compounds or a combination of two or more kinds thereof can be used. In some embodiments, the other oxidant is preferably an inorganic compound from the viewpoints of performance stability of the polishing composition (for example, prevention of deterioration caused by long-term storage) and the like.

The polishing composition disclosed herein may contain, as the other oxidant, a composite metal oxide that is a salt of a cation selected from alkali metal ions and an anion selected from transition metal oxoacid ions. The composite metal oxide is effective to, for example, reduce the hardness of a high hardness material such as silicon carbide and make the material fragile. As the composite metal oxide, one kind can be used alone or two or more kinds can be used in combination. Specific examples of the transition metal oxoacid ions in the composite transition metal oxide include permanganate ions, ferrate ions, chromate ions, dichromate ions, vanadate ions, ruthenate ions, molybdate ions, rhenate ions, tungstate ions, and the like. In particular, oxoacid of a Period-4 transition metal element in the periodic table is more preferable. Preferred examples of the Period-4 transition metal element in the periodic table include Fe, Mn, Cr, V and Ti. In particular, Fe, Mn, and Cr are more preferable, and Mn is still more preferable. An alkali metal ion in the composite transition metal oxide is preferably K⁺. In some embodiments, potassium permanganate can be preferably employed as the other oxidant.

When the compound used as the oxidant is a salt (for example, permanganate), the compound may exist as an ion in the polishing composition.

### (Abrasive)

The art disclosed herein is characterized by satisfying either (a) or (b) below regarding the abrasive:
(a) the polishing composition contains an abrasive A with a Mohs hardness of less than 8; and
(b) the polishing composition does not contain an abrasive.

By the polishing composition satisfying either the aforementioned (a) or (b) regarding the abrasive, the generation of a scratch or a dent on the surface to be polished can be suppressed easily. By the polishing composition containing sodium permanganate as the oxidant and satisfying either the aforementioned (a) or (b) regarding the abrasive, both the improvement of the polishing removal rate and the suppression of the generation of a scratch or a dent on the surface to be polished can be achieved easily. In a case where the abrasive is formed of two or more kinds of materials, the Mohs hardness of the abrasives is obtained by obtaining the product of the Mohs hardness and the mass ratio of each material and totaling the products.

The material of the abrasive A is not limited in particular as long as the Mohs hardness of the abrasive A is less than 8. For example, the abrasive A may be any of inorganic particles, organic particles, and organic-inorganic composite particles. Examples of the abrasive A include an abrasive substantially formed of any of the following: oxide particles such as silica particles, cerium oxide particles, titanium dioxide particles, magnesium oxide particles, manganese dioxide particles, zinc oxide particles, and iron oxide particles; carbonates such as calcium carbonate and barium carbonate; polymethyl methacrylate (PMMA) particles; polymethacrylate particles; polyacrylate particles; and the like. As the abrasive A, one kind may be used alone or two or more kinds may be used in combination. In particular, preferred are oxide particles such as silica particles, cerium oxide particles, manganese dioxide particles, and iron oxide particles, because of their ability to form a good surface. Specifically, silica particles are particularly preferable. In an embodiment in which silica particles are used as the abrasive A, the art disclosed herein can be applied to suitably exert an effect to suppress the generation of a scratch or a dent on the surface to be polished.

Note that, in this specification, "substantially consisting of X" or "substantially formed of X" for the composition of the abrasive means that the proportion of X in the abrasive (purity of X) is 90% or more by weight. The proportion of X in the abrasive is preferably 95% or more, more preferably 97% or more, still more preferably 98% or more, and for example, 99% or more.

The lower limit of the Mohs hardness of the abrasive A is not limited in particular. From the viewpoints of being used for polishing a high hardness material and improving the polishing removal rate, the Mohs hardness of the abrasive A is preferably 5 or more, more preferably 5.5 or more, still more preferably 6 or more, and particularly preferably 6.5 or more.

The abrasive A may be substantially formed of any of particles with a Mohs hardness of less than 8 (preferably less than 7.5). Alternatively, as the abrasive A, two or more kinds of particles with a Mohs hardness of less than 8 (preferably less than 7.5) may be used in combination. By the abrasive A as described above, the generation of a scratch or a dent on the surface to be polished can be suppressed. As long as the Mohs hardness of the abrasive A is less than 8, the abrasive A may contain particles with a Mohs hardness of less than 8 (preferably less than 7.5) as a main component (for example, the content is 75 wt% or more, preferably 80 wt% or more, and more preferably 85 wt% or more when the entire abrasive A is 100 wt%) and particles with a Mohs hardness of 8 or more as a sub-component (for example, the content is less than 25 wt%, preferably less than 20 wt%, and more preferably less than 15 wt% when the entire abrasive A is 100 wt%) in combination.

The average primary particle diameter of the abrasive A is not particularly limited. From the viewpoint of improving the polishing removal rate, the average primary particle diameter of the abrasive A can be, for example, 5 nm or more, is suitably 10 nm or more and preferably 20 nm or more, and may be 30 nm or more. From the viewpoint of further improving the polishing removal rate, in some embodiments, the average primary particle diameter of the abrasive A may be 50 nm or more, 80 nm or more, 150 nm or more, 250 nm or more, or 350 nm or more. Additionally, from the viewpoints of the surface quality after the polishing and the like, the average primary particle diameter of the abrasive A can be, for example, 5 µm or less, is preferably 3 µm or less and more preferably 1 µm or less, and may be 750 nm or less or 500 nm or less. From the viewpoints of further improving the surface quality after the polishing and the like, in some embodiments, the average primary particle diameter of the abrasive A may be 350 nm or less, 180 nm or less, 85 nm or less, or 50 nm or less.

In this specification, the average primary particle diameter refers to a particle diameter (BET particle diameter) calculated from a specific surface area measured by a BET method (BET value) in accordance with the formula: average primary particle diameter (nm) = 6000/(tme density (g/cm³) × BET value (m²/g)). The specific surface area can be measured using, for example, a surface area measurement device with the product name of "Flow Sorb II 2300", available from Micromeritics Instrument Corporation.

The average secondary particle diameter of the abrasive A may be, for example, 10 nm or more, and from the viewpoint of facilitating enhancement of the polishing removal rate, is preferably 50 nm or more and more preferably 100 nm or more, and may be 250 nm or more or 400 nm or more. The upper limit of the average secondary particle diameter of the abrasive A is suitably approximately 10 µm or less from the viewpoint of sufficiently ensuring the number of particles per unit weight. Furthermore, from the viewpoints of the surface quality after the polishing and the like, the average secondary particle diameter is preferably 5 µm or less, more preferably 3 µm or less, and for example, 1 µm or less. From the viewpoint of further improving the surface quality after the polishing, in some embodiments, the average secondary particle diameter of the abrasive A may be 600 nm or less, 300 nm or less, 170 nm or less, or 100 nm or less.

The average secondary particle diameter of the abrasive A can be measured, for the particles having a size of less than 500 nm, as the volume average particle diameter (arithmetic average diameter by volume; Mv) by dynamic light scattering, using model "UPA-UT151" available from Nikkiso Co., Ltd, for example. The particles having a size of 500 nm or more can be measured as the volume average particle diameter by an aperture electrical resistance method or the like using model "Multisizer 3" available from Beckman Coulter Inc.

In a preferred embodiment in the art disclosed herein, the polishing composition contains silica particles (silica abrasive) as the abrasive A. The silica abrasive can be selected as appropriate from various known silica particles and used. Examples of such known silica particles include colloidal silica, dry silica, and the like. In particular, use of colloidal silica is preferable. A silica abrasive containing colloidal silica can suitably achieve a good surface smoothness.

The shape (outer shape) of the silica abrasive may be globular or non-globular. For instance, specific examples of the silica abrasive having the non-globular shape include peanut-shaped (i.e., peanut shell-shaped) abrasive, cocoon-shaped abrasive, conpeito-shaped abrasive, rugby ball-shaped abrasive, and the like. In the art disclosed herein, the silica abrasive may take a primary particle form, or a secondary particle form in which a plurality of primary particles associate with one another. The silica abrasive may also contain a mixture of primary particle forms and secondary particle forms. In a preferred embodiment, at least a part of the silica abrasive is contained in a secondary particle form in the polishing composition.

The silica abrasive to be preferably employed can have an average primary particle diameter of more than 5 nm. From the viewpoints of the polishing removal rate and the like, the average primary particle diameter of the silica abrasive is preferably 15 nm or more, more preferably 20 nm or more, still more preferably 25 nm or more, and particularly preferably 30 nm or more. The upper limit of the average primary particle diameter of the silica abrasive is not particularly limited, but is suitably roughly 120 nm or less, preferably 100 nm or less, and more preferably 85 nm or less. For example, from the viewpoint of achieving both the polishing removal rate and the surface quality at a higher level, the silica abrasive having an average primary particle diameter of 12 nm or more and 80 nm or less is preferable, and the silica abrasive having an average primary particle diameter of 15 nm or more and 75 nm or less is preferable.

The average secondary particle diameter of the silica abrasive is not particularly limited, but from the viewpoints of the polishing removal rate and the like, is preferably 20 nm or more, more preferably 50 nm or more, and still more preferably 70 nm or more. Furthermore, from the viewpoint of obtaining a higher-quality surface, the average secondary particle diameter of the silica abrasive is suitably 500 nm or less, preferably 300 nm or less, more preferably 200 nm or less, still more preferably 130 nm or less, and particularly preferably 110 nm or less (for example, 100 nm or less).

The true specific gravity (true density) of the silica particles is preferably 1.5 or more, more preferably 1.6 or more, and still more preferably 1.7 or more. Increase of the true specific gravity of the silica particles leads to tendency to a higher physical ability for polishing. The upper limit of the true specific gravity of the silica particles is not particularly limited, but is typically 2.3 or less, for example 22 or less, 2.0 or less, or 1.9 or less. As the true specific gravity of the silica particles, a measured value by a liquid displacement method using ethanol as a displacing liquid can be employed.

The shape (outer shape) of the silica particles is preferably globular. Without particular limitation, the average value of the major axis/minor axis ratios of the particles (average aspect ratio) is theoretically 1.00 or more, and may alternatively be, for example, 1.05 or more or 1.10 or more from the viewpoint of improving the polishing removal rate. Moreover, the average aspect ratio of the particles is suitably 3.0 or less, and may be 2.0 or less. From the viewpoints of improving the smoothness of a surface to be polished and reducing scratches, the average aspect ratio of the particles is preferably 1.50 or less, and may be 1.30 or less or 1.20 or less.

The shape (outer shape) and the average aspect ratio of the particles can be acquired by, for example, electron microscopy. A specific procedure for acquiring the average aspect ratio can be, for example, extracting shapes of a predetermined number (for example, 200) of particles using a scanning electron microscope (SEM); drawing a minimum rectangle circumscribed to a shape of each of the extracted particles; then calculating, as a major axis/minor axis ratio (aspect ratio), a value by dividing the long side length (major axis value) by the short side length (minor axis value) for the rectangle drawn for the shape of each of the particles; and deriving the average aspect ratio from an arithmetic average of the aspect ratios for the predetermined number of particles.

From the viewpoint of suppressing the generation of a scratch or a dent on the surface to be polished, the content of the abrasive A (for example, silica abrasive) in the polishing composition disclosed herein is suitably less than 10 wt%, advantageously less than 5 wt%, preferably less than 3 wt% (for example, less than 1 wt%), more preferably less than 0.5 wt%, and still more preferably 0.3 wt% or less (for example, 0.15 wt% or less). In some preferred embodiments, the content of the abrasive A may be 0.1 wt% or less or 0.05 wt% or less. The lower limit of the content of the abrasive A is not particularly limited, and may be, for example, 0.000001 wt% or more (i.e., 0.01 ppm or more). From the viewpoint of enhancing an effect of use of the abrasive A, in some embodiments, the content of the abrasive A in the polishing composition may be 0.00001 wt% or more, 0.0001 wt% or more, 0.001 wt% or more, 0.002 wt% or more, or 0.005 wt% or more. In some embodiments, the content of the abrasive A in the polishing composition may be 0.01 wt% or more, 0.02 wt% or more, 0.03 wt% or more, more than 0.1 wt%, more than 0.3 wt%, 0.5 wt% or more, or 0.8 wt% or more. When the polishing composition disclosed herein contains a plurality kinds of abrasives, the content of the abrasive in the polishing composition refers to the total content of the plurality kinds of abrasives.

It is preferable that the polishing composition disclosed herein do not substantially contain diamond particles as the particles. Diamond particles have high hardness and thus can be a factor for limited improvement in smoothness. Diamond particles are also generally expensive and thus are not necessarily a beneficial material in terms of cost performance, and there may be less dependence on high-price materials such as diamond particles in terms of practical use. The particles not substantially containing diamond particles, as used herein, mean that the proportion of diamond particles in all the particles is 1 wt% or less, more preferably 0.5 wt% or less, and typically 0.1 wt% or less, including a case where the proportion of the diamond particles is 0 wt%. In such an embodiment, an application effect of the present invention can be preferably exerted.

When containing the abrasive A as the abrasive, the polishing composition disclosed herein may further contain an abrasive B with a Mohs hardness of 8 or more as far as an effect in the present invention is not impaired. Examples of the abrasive B include an abrasive substantially formed of any of alumina particles, zirconium oxide particles, and chromium oxide particles. The content of the abrasive B is suitably, for example, 30 wt% or less, preferably 20 wt% or less, and more preferably 10 wt% or less in the total weight of the abrasive contained in the polishing composition.

In some preferred embodiments, the polishing composition does not substantially contain the abrasive B. Because of having relatively high hardness, the abrasive B tends to cause a scratch or a dent on the surface to be polished. Not substantially containing the abrasive B, as used herein, means that the proportion of the abrasive B in the entire weight of the abrasive contained in the polishing composition is 1 wt% or less, more preferably 0.5 wt% or less, and typically 0.1 wt% or less, including a case where the proportion of the abrasive B is 0 wt%. In such an embodiment, an application effect of the present invention can be preferably exerted.

In some preferred embodiments, the polishing composition disclosed herein contains no abrasive. In such embodiments, the effect of suppressing the generation of a scratch or a dent on the surface to be polished can be exerted more. In an embodiment in which the polishing composition contains sodium permanganate as the oxidant and does not contain the abrasive, the improvement of the polishing removal rate and the improvement of the surface quality after the polishing can be easily achieved suitably.

In the polishing composition containing the abrasive, the relation between the content of the oxidant and the content of the abrasive is not particularly limited, and can be set suitably so as to achieve a desired effect corresponding to a purpose of use and an embodiment of use. A ratio of a content Wx (wt%) of the oxidant to a content Wp (wt%) of the abrasive, i.e., Wx/Wp, can be, for example, approximately 0.01 or more, is suitably 0.025 or more, may be 0.03 or more, 0.05 or more, 0.1 or more, 0.2 or more, or 1 or more, and is advantageously 5 or more, preferably 8 or more, and more preferably 10 or more. Larger Wx/Wp tends to be accompanied by larger contribution of chemical polishing relative to contribution of mechanical polishing. In some embodiments, WxAVp may be 20 or more, 60 or more, 80 or more, 90 or more, 150 or more, or 200 or more. The upper limit of Wx/Wp is not limited in particular; however, from the viewpoints of the storage stability of the polishing composition and the like, the upper limit ofWx/Wp can be, for example, approximately 5000 or less, and may be 1500 or less, 1000 or less, 800 or less, or 400 or less.

Note that in the "Wx/Wp" described above, "Wx" refers to a numerical value part in indication of the content of the oxidant in the polishing composition by a unit "wt%", "Wp" refers to a numerical value part in indication of the content of the abrasive in the polishing composition by a unit "wt%", and both Wx and Wp are dimensionless numbers.

### (Metal salt)

In some embodiments, the polishing composition disclosed herein further contains, as a polishing accelerator, a metal salt that is different from the oxidant. In the embodiment in which the oxidant is contained, using the metal salt tends to improve the polishing removal rate further. Moreover, using the metal salt tends to suppress the deterioration of performance of the polishing composition (for example, reduction in polishing removal rate or the like).

### (First metal salt)

In some preferred embodiments, the polishing composition contains the first metal salt selected from alkaline earth metal salts. As the first metal salt, one kind of alkaline earth metal salt may be used alone or two or more kinds of alkaline earth metal salts may be used in combination. Using the first metal salt can improve the polishing removal rate. The first metal salt preferably contains one kind or two or more kinds of Mg, Ca, Sr, and Ba as the element that belongs to the alkaline earth metals. In particular, one of Ca and Sr is preferable and Ca is more preferable.

The kind of salt in the first metal salt is not particularly limited, and may be an inorganic acid salt or an organic acid salt. Examples of the inorganic acid salt include salts of hydrohalic acid such as hydrochloric acid, hydrobromic acid, and hydrofluoric acid; nitric acid; sulfuric acid; carbonic acid; silicic acid; boric acid; phosphoric acid; and the like. Examples of the organic acid salt include salts of carboxylic acids such as formic acid, acetic acid, propionic acid, benzoic acid, glycine acid, butyric acid, citric acid, tartaric acid, and trifluoroacetic acid; organic sulfonic acids such as methanesulfonic acid, trifluoromethanesulfonic acid, benzenesulfonic acid, and toluenesulfonic acid; organic phosphonic acids such as methylphosphonic acid, benzenephosphonic acid, and toluenephosphonic acid; organic phosphoric acid such as ethylphosphoric acid; and the like. In particular, preferred are salts of hydrochloric acid, nitric acid, sulfuric acid, and phosphoric acid, and more preferred are salts of hydrochloric acid and nitric acid. The art disclosed herein can be preferably implemented in an embodiment in which nitrate or chloride of alkaline earth metal is used as the first metal salt, for example.

Specific examples of the alkaline earth metal salt to be a potential option of the first metal salt include: chlorides such as magnesium chloride, calcium chloride, strontium chloride, and barium chloride; bromides such as magnesium bromide, calcium bromide, strontium bromide, and barium bromide; fluorides such as magnesium fluoride, calcium fluoride, strontium fluoride, and barium fluoride; nitrates such as magnesium nitrate, calcium nitrate, strontium nitrate, and barium nitrate; sulfates such as magnesium sulfate, calcium sulfate, strontium sulfate, and barium sulfate; carbonates such as magnesium carbonate, calcium carbonate, strontium carbonate, and barium carbonate; carboxylates such as magnesium acetate, calcium acetate, strontium acetate, barium acetate, magnesium benzoate, calcium benzoate, barium benzoate, magnesium citrate, calcium citrate, strontium citrate, and barium citrate; and the like.

The first metal salt is preferably a water-soluble salt. Use of the first metal salt with water solubility can efficiently form a good surface with fewer defects such as a scratch.

In addition, the first metal salt is preferably a compound that is not oxidized by the oxidant. Appropriate selection of the oxidant and the first metal salt in accordance with such a viewpoint allows preventing deactivation of the oxidant due to oxidization of the first metal salt by the oxidant, and suppressing age-related deterioration of performance of the polishing composition (for example, reduction in polishing removal rate or the like). From such a viewpoint, calcium nitrate is given as the preferred first metal salt.

When the polishing composition contains the first metal salt, the concentration (content) of the first metal salt in the polishing composition is not particularly limited, and can be appropriately set so as to achieve a desired effect, corresponding to a purpose of use and an embodiment of use of the polishing composition. The concentration of the first metal salt may be, for example, approximately 1000 mM or less (that is, 1 mol/L or less), 500 mM or less, or 300 mM or less. The concentration of the first metal salt in some embodiments is suitably 200 mM or less, preferably 100 mM or less, and more preferably 50 mM or less, and may be 30 mM or less, 20 mM or less, or 10 mM or less. The lower limit of the concentration of the first metal salt may be, for example, 0.1 mM or more, and from the viewpoint of suitably exerting an effect of use of the first metal salt, is preferably 0.5 mM or more and more preferably 1 mM or more, and may be 2.5 mM or more, 5 mM or more, 10 mM or more, 20 mM or more, or 30 mM or more.

When the polishing composition contains the first metal salt, without particular limitation, from the viewpoint of better exerting an effect caused by containing the first metal salt in the polishing composition containing the oxidant, a ratio (CS1/Wx) of a concentration CS1 (mM) of the first metal salt (represented by the total concentration if containing a plurality of first metal salts) to the content Wx (wt%) of the oxidant (represented by the total content if containing a plurality of oxidants) in the polishing composition is normally 0 or more, preferably 0.01 or more, and more preferably 0.025 or more, and may be 0.05 or more, 0.1 or more, or 0.5 or more. In some embodiments, CS 1/Wx may be, for example, 0.8 or more, 1.0 or more, 2.0 or more, 2.5 or more, or 3.0 or more. The upper limit of CS 1/Wx is not particularly limited, but may be, for example, 300 or less and is suitably roughly 100 or less, and preferably 75 or less, more preferably 50 or less, and still more preferably 25 or less. In some preferred embodiments, CS 1/Wx may be 20 or less, 10 or less, 5 or less, 4 or less, 3 or less, 2 or less, or 1 or less.

Note that in the "CS1/Wx" described above, "CS1" refers to a numerical value part in indication of the concentration (content) of the first metal salt in the polishing composition by a unit "mM", "Wx" refers to a numerical value part in indication of the content of the oxidant in the polishing composition by a unit "wt%", and both CS1 and Wx are dimensionless numbers.

### (Second metal salt)

In some preferred embodiments, the polishing composition contains the second metal salt selected from salts of cations containing metals that belong to Groups 3 to 16 in the periodic table, and anions. As the second metal salt, one kind of metal salts selected from salts of cations containing metals that belong to Groups 3 to 16 in the periodic table, and anions can be used alone, or two or more kinds of such metal salts can be used in combination. Using the second metal salt can improve the polishing removal rate.

The cation of the second metal salt may be a cation containing a transition metal, which is a metal belonging to Groups 3 to 12 in the periodic table, or a cation containing a poor metal, which is a metal belonging to Groups 13 to 16. The transition metal is preferably a metal belonging to Groups 4 to 11 in the periodic table, and also suitably a metal belonging to Periods 4 to 6 in the periodic table, preferably a metal belonging to Periods 4 and 5, and more preferably a metal belonging to Period 4. The poor metal is preferably a metal belonging to Groups 13 to 15 in the periodic table, more preferably a metal belonging to Groups 13 and 14, and also preferably a metal belonging to Periods 3 to 5 in the periodic table, more preferably a metal belonging to Periods 3 and 4, and particularly preferably a poor metal belonging to Period 3, i.e., aluminum.

In some embodiments, the second metal salt is preferably a salt of a cation containing a metal exhibiting a pKa of approximately less than 7 in form of a hydrated metal ion, and an anion. The second metal salt that is a salt of such a cation and an anion generates a hydrated metal cation in water, and in the hydrated metal cation, protons in coordinated water are in adsorption equilibrium; therefore, the action as a pH buffer is obtained and thus, age-related deterioration of performance of the polishing composition can be suppressed easily. From such a viewpoint, the second metal salt to be potentially employed can be preferably a salt of a metal cation exhibiting a pKa of less than 7.0 or less than or equal to 6.0, for example, in form of a hydrated metal ion, and an anion. Examples of the metal cation exhibiting a pKa of less than or equal to 6.0 in form of the hydrated metal ion include, but are not limited to, Al³⁺ (exhibiting a pKa of 5.0 in form of a hydrated metal ion), Cr' (4.0), Fe³⁺(2.2), ZrO²⁺ (-0.3), Ga³⁺ (2.6), and In³⁺ (4.0).

The kind of salt in the second metal salt is not particularly limited, and may be an inorganic acid salt or an organic acid salt. Examples of the inorganic acid salt include salts of hydrohalic acid such as hydrochloric acid, hydrobromic acid, and hydrofluoric acid; nitric acid; sulfuric acid; carbonic acid; silicic acid; boric acid; phosphoric acid; and the like. Examples of the organic acid salt include salts of carboxylic acids such as formic acid, acetic acid, propionic acid, benzoic acid, glycine acid, butyric acid, citric acid, tartaric acid, and trifluoroacetic acid; organic sulfonic acids such as methanesulfonic acid, trifluoromethanesulfonic acid, benzenesulfonic acid, and toluenesulfonic acid; organic phosphonic acids such as methylphosphonic acid, benzenephosphonic acid, and toluenephosphonic acid; organic phosphoric acid such as ethylphosphoric acid; and the like. In particular, preferred are salts of hydrochloric acid, nitric acid, sulfuric acid and phosphoric acid, and more preferred are salts of hydrochloric acid, nitric acid, and sulfuric acid. The art disclosed herein can be preferably implemented in an embodiment, for example, with the use of a salt of any cation of Al³⁺, Cr³⁺ Fe³⁺, ZrO²⁺, Ga³⁺, and In³⁺, and a nitrate ion (NO₃⁻) or a chloride ion (Cl⁻), as the second metal salt.

The second metal salt is preferably a water-soluble salt. Use of the second metal salt with water solubility can efficiently form a good surface with fewer defects such as a scratch.

In addition, the second metal salt is preferably a compound that is not oxidized by the oxidant. Appropriate selection of the oxidant and the second metal salt in accordance with such a viewpoint allows preventing deactivation of the oxidant due to oxidization of the second metal salt by the oxidant, and suppressing age-related deterioration of perfonnance of the polishing composition (for example, reduction in polishing removal rate or the like). From such a viewpoint, aluminum nitrate, aluminum chloride, and the like are given as the preferred second metal salt.

When the polishing composition contains the second metal salt, the concentration (content) of the second metal salt in the polishing composition is not particularly limited, and can be appropriately set so as to achieve a desired effect, corresponding to a purpose of use and an embodiment of use of the polishing composition. The concentration of the second metal salt may be, for example, approximately 1000 mM or less (that is, 1 mol/L or less), 500 mM or less, or 300 mM or less. The concentration of the second metal salt in some embodiments is suitably 200 mM or less, preferably 100 mM or less, and more preferably 50 mM or less, and may be 40 mM or less, 35 mM or less, or 32 mM or less. The lower limit of the concentration of the second metal salt may be, for example, 0.1 mM or more, and from the viewpoint of suitably exerting an effect of use of the second metal salt, is advantageously 1 mM or more, preferably 5 mM or more, and more preferably 10 mM or more (for example, 15 mM or more), and may be 20 mM or more or 25 mM or more.

When the polishing composition contains the second metal salt, without particular limitation, from the viewpoint of better exerting an effect caused by containing the second metal salt in the polishing composition containing the oxidant, a ratio (CS2/Wx) of a concentration CS2 (mM) of the second metal salt (represented by the total concentration if containing a plurality of second metal salts) to the content Wx (wt%) of the oxidant (represented by the total content if containing a plurality of oxidants) in the polishing composition is normally 0 or more, preferably 0.01 or more, and more preferably 0.025 or more, and may be 0.05 or more, 0.1 or more, or 0.5 or more. In some embodiments, CS2/Wx may be, for example, 0.8 or more, 1.0 or more, 2.0 or more, 2.5 or more, or 3.0 or more. The upper limit of CS2/Wx is not particularly limited, but is suitably roughly 500 or less, may be 300 or less, and is preferably 200 or less, more preferably 100 or less, and still more preferably 50 or less. In some preferred embodiments, CS2/Wx may be 25 or less, 20 or less, 12 or less, 9 or less, 7 or less, 4 or less, 3 or less, or 2 or less.

Note that in the "CS2/Wx" described above, "CS2" refers to a numerical value part in indication of the concentration (content) of the second metal salt in the polishing composition by a unit "mM", "Wx" refers to a numerical value part in indication of the content of the oxidant in the polishing composition by a unit "wt%", and both CS2 and Wx are dimensionless numbers.

In some preferred embodiments, the polishing composition may contain the first metal salt and the second metal salt in combination. In some preferred embodiments in which the first metal salt and the second metal salt are contained in combination, the first metal salt and the second metal salt have the same anion species. The anion species common in the first metal salt and the second metal salt may be, for example, nitric acid, hydrochloric acid, phosphoric acid, or the like. From the viewpoint of providing a higher effect, it is particularly preferable that both the first metal salt and the second metal salt in the polishing composition be nitrates.

When the polishing composition contains the first metal salt and the second metal salt in combination, the relation between the concentration CS 1 (mM) of the first metal salt and the concentration CS2 (mM) of the second metal salt in the polishing composition is not particularly limited, and can be set so as to appropriately exert an effect caused by the combination use thereof. For example, CS 1/CS2 may fall within the range of 0.001 to 1000. From the viewpoint of improving the polishing removal rate, in some embodiments, CS1/CS2 is suitably approximately 0.01 or more, and preferably 0.05 or more (for example, 0.1 or more). CS 1/CS2 is also suitably approximately 100 or less and preferably 50 or less, may be 30 or less, and is more preferably 25 or less (for example, 10 or less).

In the polishing composition containing the abrasive and the first metal salt, the relation between the concentration of the first metal salt and the content of the abrasive is not particularly limited, and can be set suitably so as to achieve a desired effect corresponding to a purpose of use and an embodiment of use. A ratio of the concentration CS 1 (mM) of the first metal salt (represented by the total concentration if containing a plurality of first metal salts) to the content Wp (wt%) of the abrasive (represented by the total content if containing a plurality of abrasives), i.e., CS 1/Wp, can be, for example, 0.05 or more, is suitably 0.1 or more, may be 0.2 or more, 1 or more, 3 or more, or 5 or more, is preferably 10 or more and more preferably 30 or more, and may be 50 or more or 90 or more. Larger CS1/Wp tends to be accompanied by larger contribution of chemical polishing relative to contribution of mechanical polishing. In some embodiments, CS 1/Wp may be 100 or more, 200 or more, or 500 or more. The upper limit of CS 1/Wp is not particularly limited; however, from the viewpoints of the storage stability of the polishing composition and the like, the upper limit of CS1/Wp can be, for example, approximately 10000 or less, and may be 5000 or less, 2500 or less, 1000 or less, 500 or less, or 300 or less. In some embodiments, CS1/Wp may be 200 or less, 150 or less, or 120 or less.

Note that in the "CS1/Wp" described above, "CS1" refers to a numerical value part in indication of the concentration of the first metal salt in the polishing composition by a unit "mM", "Wp" refers to a numerical value part in indication of the content of the abrasive in the polishing composition by a unit "wt%", and both Wp and CS1 are dimensionless numbers.

In the polishing composition containing the abrasive and the second metal salt, the relation between the concentration of the second metal salt and the content of the abrasive is not particularly limited, and can be set suitably so as to achieve a desired effect corresponding to a purpose of use and an embodiment of use. A ratio of the concentration CS2 (mM) of the second metal salt (represented by the total content if containing a plurality of second metal salts) to the content Wp (wt%) of the abrasive (represented by the total content if containing a plurality of abrasives), i.e., CS2/Wp, can be, for example, 0.05 or more, is suitably 0.1 or more, may be 0.2 or more, 1 or more, 3 or more, or 5 or more, is preferably 10 or more and more preferably 30 or more, and may be 50 or more or 90 or more. Larger CS2/Wp tends to be accompanied by larger contribution of chemical polishing relative to contribution of mechanical polishing. In some embodiments, CS2/Wp may be 100 or more, 200 or more, 300 or more, or 500 or more. The upper limit of CS2/Wp is not limited in particular; however, from the viewpoints of the storage stability of the polishing composition and the like, the upper limit of CS2/Wp can be, for example, approximately 20000 or less, and may be 10000 or less, 5000 or less, 2500 or less, or 1000 or less. In some embodiments, CS2/Wp may be 800 or less, 500 or less, or 350 or less.

Note that in the "CS2/Wp" described above, "CS2" refers to a numerical value part in indication of the concentration of the second metal salt in the polishing composition by a unit "mM", "Wp" refers to a numerical value part in indication of the content of the abrasive in the polishing composition by a unit "wt%", and both CS2 and Wp are dimensionless numbers.

### (Water)

The polishing composition disclosed herein contains water. As the water, ion-exchange water (deionized water), pure water, ultrapure water, distilled water, or the like can be preferably used. The polishing composition disclosed herein may further contain an organic solvent (lower alcohol, lower ketone, or the like) that can be uniformly mixed with water, as necessary. Usually, it is appropriate that 90 vol% or more of the solvent contained in the polishing composition be water, it is preferable that 95 vol% or more thereof be water, and it is more preferable that 99 to 100 vol% thereof be water.

### (Acid)

The polishing composition can contain an acid as necessary, for the purposes of the pH adjustment, improvement of the polishing removal rate, and the like. As the acid, both inorganic and organic acids can be used. Examples of the inorganic acids include sulfuric acid, nitric acid, hydrochloric acid, carbonic acid, and the like. Examples of the organic acids include aliphatic carboxylic acids such as formic acid, acetic acid, and propionic acid; aromatic carboxylic acids such as benzoic acid and phthalic acid; citric acid; oxalic acid; tartaric acid; malic acid; maleic acid; fumaric acid; succinic acid; organic sulfonic acid; organic phosphonic acid; and the like. One kind of these can be used alone or two or more kinds thereof can be used in combination. When using an acid, the amount to be used is not particularly limited, and can be set according to a purpose of use (for example, pH adjustment). Alternatively, in some embodiments of the polishing composition disclosed herein, the polishing composition may contain substantially no acid.

### (Basic compound)

The polishing composition can contain a basic compound as necessary, for the purposes of the pH adjustment, improvement of the polishing removal rate, and the like. The basic compound as used herein refers to a compound that has a function to raise the pH of the polishing composition by being added to the composition. Examples of the basic compound include alkali metal hydroxides such as potassium hydroxide and sodium hydroxide; carbonates or hydrogencarbonates such as ammonium bicarbonate, ammonium carbonate, potassium bicarbonate, potassium carbonate, sodium bicarbonate, and sodium carbonate; ammonia; quaternary ammonium compounds including quaternary ammonium hydroxides such as tetramethylammonium hydroxide, tetraethylammonium hydroxide, and tetrabutylammonium hydroxide; others, such as amines, phosphates and hydrogen phosphates, and organic acid salts; and the like. As the basic compound, one kind can be used alone or two or more kinds can be used in combination. In use of the basic compound, the amount to be used is not particularly limited, and can be set according to a purpose of use (for example, pH adjustment). Alternatively, in some embodiments of the polishing composition disclosed herein, the composition may contain substantially no basic compound.

### (Other components)

The polishing composition disclosed herein may further contain, as necessary, a known additive that can be used for polishing compositions (for example, a polishing composition used for polishing a high hardness material such as silicon carbide), such as a chelating agent, a thickener, a dispersant, a surface protective agent, a wetting agent, a surfactant, a corrosion inhibitor, an antiseptic agent, or an antifungal agent, as far as an effect of the present invention is not impaired. Since the content of the additive only has to be appropriately set according to the purpose of addition thereof and does not characterize the present invention, a detailed description thereof will be omitted.

### (pH)

The pH of the polishing composition is suitably about 1 to 12. The pH within this range facilitates the achievement of a practical polishing removal rate. In some embodiments, the pH may be 12.0 or less, 11.0 or less, 10.0 or less, 9.0 or less, less than 9.0, 8.0 or less, less than 8.0, 7.0 or less, less than 7.0, or 6.0 or less. From the viewpoint of further facilitating the exertion of the effect to improve the polishing removal rate by the use of the metal salt, in some embodiments, the pH of the polishing composition is preferably less than 6.0, and may be 5.0 or less, less than 5.0, 4.0 or less, or less than 4.0. The pH may be, for example, 1.0 or more, 1.5 or more, 2.0 or more, or 2.5 or more.

A method for preparing the polishing composition disclosed herein is not particularly limited. For example, each component to be contained in the polishing composition may be mixed using a well-known mixing device such as a blade stirrer, an ultrasonic disperser, or a homomixer. An embodiment for mixing these components is not particularly limited, and for example, all components may be mixed at once or in an appropriately set order.

The polishing composition disclosed herein may be a single-agent type or a multi-agent type such as a two-agent type. For example, the polishing composition may be configured to be used for polishing an obj ect to be polished, by mixing of a part A, which contains a part of the components of the polishing composition (for example, components other than water), and a part B, which contains the remaining components. These components may be, for example, separately stored before use, and then mixed in use to prepare the polishing composition in a single liquid. In mixing, dilution water or the like may be further mixed.

### <Object to be polished>

The object to be polished with the polishing composition disclosed herein is not particularly limited. For example, the polishing composition disclosed herein can be applied to polishing of a substrate having a surface formed of a compound semiconductor material, i.e., a compound semiconductor substrate. A component material of the compound semiconductor substrate is not particularly limited, and examples thereof can include Group II-VI compound semiconductors such as cadmium telluride, zinc selenide, cadmium sulfide, mercury cadmium telluride, and cadmium zinc telluride; Group III-V compound semiconductors such as gallium nitride, gallium arsenide, gallium phosphide, indium phosphide, aluminum gallium arsenide, gallium indium arsenide, indium gallium arsenide nitride, and aluminum gallium indium phosphide; Group IV-IV compound semiconductors such as silicon carbide and germanium silicide; and the like. A plurality of the materials listed above may form an object to be polished. In a preferred embodiment, the polishing composition disclosed herein can be applied to polishing of a substrate having a surface formed of a chemical semiconductor material other than oxides (i.e., a non-oxide). Polishing of a substrate having a surface formed of a non-oxide chemical semiconductor material is likely to lead to preferable exertion of an effect to promote polishing by the oxidant contained in the polishing composition disclosed herein.

The polishing composition disclosed herein can be preferably used for polishing, for example, a surface of an object to be polished having a Vickers hardness of 500 Hv or more. The Vickers hardness as described above is preferably 700 Hv or more, and for example, 1000 Hv or more or 1500 Hv or more. The Vickers hardness of the material to be polished may be 1800 Hv or more, 2000 Hv or more, or 2200 Hv or more. The upper limit of the Vickers hardness of the surface of the object to be polished is not particularly limited, and may be, for example, approximately 7000 Hv or less, 5000 Hv or less, or 3000 Hv or less. In this specification, the Vickers hardness can be measured in accordance with JIS R 1610: 2003. The international standard corresponding to this standard in JIS is ISO 14705: 2000.

Examples of the material having a Vickers hardness of 1500 Hv or more include silicon carbide, silicon nitride, titanium nitride, gallium nitride, and the like. The object to be polished in the art disclosed herein may have a monocrystalline surface of the material with mechanical and chemical stability. In particular, the surface of the object to be polished is preferably formed of either silicon carbide or gallium nitride, and more preferably formed of silicon carbide. Silicon carbide has been expected as a compound semiconductor substrate material having less power loss and good heat resistance, etc., and thus there is a particularly large practical advantage of improvement of productivity by increasing the polishing removal rate. The art disclosed herein can be particularly preferably applied to polishing of a monocrystalline surface of silicon carbide.

### <Polishing method>

The polishing composition disclosed herein can be used for polishing an object to be polished in an exemplary embodiment including the following operations.

That is, a polishing slurry (slurry) containing any of the polishing compositions disclosed herein is prepared. Preparation of the polishing slurry may include preparing the polishing slurry by having the polishing composition subjected to operations such as concentration adjustment (for example, dilution) and pH adjustment. Alternatively, the polishing composition may be directly used as the polishing slurry: In use of a multi-agent type polishing composition, the preparation of the polishing slurry may include mixing the agents thereof, diluting one or more of the agents before the mixing, diluting the resulting mixture after the mixing, and the like.

Next, the polishing slurry is supplied to the object to be polished, and the polishing is performed by a common method performed by those skilled in the art. For example, one method is to set the object to be polished in a common polishing machine and supply the polishing slurry to the surface to be polished of the object to be polished through a polishing pad of the polishing machine. Typically, while supplying the polishing slurry continuously, the polishing pad is pressed against the surface to be polished of the object to be polished, and both of the surface and the polishing pad are moved (for example, rotated) relative to each other. The polishing of the object to be polished is completed through such a polishing step.

Note that the aforementioned content (concentration) and content (concentration) ratio for each component that can be contained in the polishing composition in the art disclosed herein typically mean the content and content ratio in the polishing composition in practical supply to the object to be polished (i.e., at a point of use), and therefore can be translated as the content and content ratio in the polishing slurry.

This specification provides a polishing method for polishing the object to be polished (typically, material to be polished) and a manufacturing method for a polished object using the polishing method. The polishing method is characterized by including a step of polishing the object to be polished using the polishing composition disclosed herein. The polishing method according to one preferred embodiment includes a step of performing preliminary polishing (preliminary polishing step) and a step of performing final polishing (final polishing step). In one typical embodiment, the preliminary polishing step is a polishing step set immediately before the final polishing step. The preliminary polishing step may be a single-step polishing step or a polishing step including two or more sub-steps. The final polishing step as referred to herein designates a step of applying final polishing to an object to be polished that experienced the preliminary polishing, specifically, a polishing step set at the end (i.e., on the most downstream) of polishing steps performed with a polishing slurry containing an abrasive. In such a polishing method including the preliminary polishing step and the final polishing step, the polishing composition disclosed herein may be used in the preliminary polishing step, may be used in the final polishing step, or may be used in both the preliminary polishing step and the final polishing step.

The preliminary polishing and the final polishing can be applied to polishing using either a single-side polishing machine or a double-side polishing machine. In the single-side polishing machine, one side of an object to be polished is polished by attaching the object to be polished to a ceramic plate with wax, holding the object to be polished with a holder called a carrier, and then pressing a polishing pad against one side of the object to be polished and moving both relative to each other while supplying the polishing composition. This movement is, for example, rotational movement. In the double-side polishing machine, both sides of an object to be polished are polished simultaneously by holding the object to be polished with a holder called a carrier, and then pressing polishing pads against opposing sides of the object to be polished and rotating them relative to one another while supplying the polishing composition from above.

Conditions of the polishing described above are appropriately set based on the kind of a material to be polished, intended surface properties (specifically, smoothness), the polishing removal rate, and the like, and thus are not limited to particular conditions. For example, with regard to processing pressure, the polishing composition disclosed herein can be used within a wide pressure range of, for example, 10 kPa or more and 150 kPa or less. From the viewpoint of improving the polishing removal rate, in some embodiments, the processing pressure may be, for example, 20 kPa or more, 30 kPa or more, or 40 kPa or more, and can also be 100 kPa or less, 80 kPa or less, or 60 kPa or less. The polishing composition disclosed herein can also be preferably used in polishing under processing conditions, for example, with 30 kPa or more or higher thereby allowing enhancing the productivity of a target product (polished object) derived via the aforementioned polishing. The processing pressure referred to herein is synonymous with polishing pressure.

The polishing pad used in each polishing step disclosed herein is not particularly limited. For example, any of a non-woven fabric type, a suede type, and a hard foamed polyurethane type may be used. In some embodiments, a hard foamed polyurethane type polishing pad can be preferably employed. The polishing pad used in the art disclosed herein is an abrasive-free polishing pad.

The object to be polished that is polished by the method disclosed herein is typically cleaned after the polishing. This cleaning can be performed using a suitable cleaning solution. The cleaning solution to be used is not particularly limited, and a known or conventional cleaning solution can be selected as appropriate and used.

The polishing method disclosed herein may include any other step in addition to the preliminary polishing step and final polishing step described above. Examples of such a step include a mechanical polishing step and a lapping step performed before the preliminary polishing step. In the mechanical polishing step, the object to be polished is polished with a liquid in which a diamond abrasive is dispersed in a solvent. In some preferred embodiments, the dispersion contains no oxidant. The lapping step is a step of polishing by pressing a surface of a polishing platen, such as a cast iron platen, to the object to be polished. Therefore, in the lapping step, the polishing pad is not used. The lapping step is typically performed by supplying an abrasive between a polishing platen and an object to be polished. The abrasive is typically a diamond abrasive. In addition, the polishing method disclosed herein may include an additional step before the preliminary polishing step or between the preliminary polishing step and the final polishing step. The additional step is, for example, a cleaning step or a polishing step.

### <Manufacturing method for polished object>

The art disclosed herein may include provision of a manufacturing method for a polished object that includes the polishing step with use of any of the polishing methods described above and a polished object manufactured by the method. The manufacturing method for the polished object is, for example, a manufacturing method for a silicon carbide substrate. That is to say, the art disclosed herein provides a manufacturing method for a polished object that includes polishing an object to be polished having a surface made of a high hardness material by applying any of the polishing methods disclosed herein, and also provides a polished object manufactured by the method. The manufacturing method described above can efficiently provide a substrate manufactured via polishing, such as a silicon carbide substrate.

### [Examples]

Several examples relating to the present invention will be described below, but the present invention is not intended to be limited to embodiments shown in the examples. In the following description, "%" is on a weight basis unless otherwise specified.

### <<Experimental Example 1>>

### <Preparation of polishing composition>

### (Example 1)

A silica abrasive, sodium permanganate as the oxidant, and deionized water were mixed to prepare a polishing composition containing the silica abrasive at a concentration of 0.1% and sodium permanganate at a concentration of 1.4%. The pH of the polishing composition in this example was made 3.0 by using nitric acid. As the silica abrasive, colloidal silica with an average primary particle diameter of 35 nm was used.

### (Example 2 to Example 7)

Polishing compositions according to these examples were prepared in a manner similar to Example 1 except that the concentration of sodium permanganate was set as shown in Table 1.

### (Example 8)

An alumina abrasive, sodium permanganate as the oxidant, and deionized water were mixed to prepare a polishing composition containing the alumina abrasive at a concentration of 1.0% and sodium permanganate at a concentration of 1.4%. The pH of the polishing composition in this example was made 3.0 by using nitric acid. As the alumina abrasive, an α-alumina abrasive with an average primary particle diameter of 310 nm was used.

### (Example 9 to Example 16)

Polishing compositions according to these examples were prepared in a manner similar to Example 8 except that the concentration of sodium permanganate was set as shown in Table 1.

### <Polishing of object to be polished>

A SiC wafer was preliminarily polished using a preliminary polishing composition containing an alumina abrasive. The preliminarily polished SiC wafer was set as the object to be polished, and polished under the following polishing conditions using directly each polishing composition according to the corresponding example as the polishing slurry.

### [Polishing conditions]

Polishing machine: model "RDP-500", available from Fujikoshi Machinery Corp.
Polishing pad: "IC-1000" (hard polyurethane type), available from NITTA DuPont Incorporated
Processing pressure: 490 gf/cm²
Platen rotational speed: 130 revolutions/min.
Head rotational speed: 130 revolutions/min.
Supply rate of polishing slurry: 20 mL/min.
Method of using polishing slurry: one-way
Polishing time: 5 mins.
Object to be polished: 4-inch SiC wafer (conduction type: n-type, crystalline type: 4H-SiC, off angle to the C-axis of the main surface (0001): 4°), 1 sheet/batch
Temperature of polishing slurry: 23°C

As the polishing pad, the polishing pad whose polishing surface was subjected to a brush dressing process for five minutes, a diamond dressing process for three minutes, and another brush dressing process for five minutes was used. The brush dressing processes and the diamond dressing process were performed before the aforementioned polishing.

### <Measurement and evaluation>

### (Polishing removal rate)

After the SiC wafer was polished under the aforementioned polishing conditions using each polishing composition of the corresponding example, the polishing removal rate was calculated according to the following calculation formulae (1) and (2):
(1) polishing allowance (cm) = difference between weight of SiC wafer before and after polishing (g)/density of SiC (g/cm³) (= 3.21 g/cm³)/area to be polished (cm²) (= 78.54 cm²); and
(2) polishing removal rate (nm/h) = polishing allowance (cm) × 10⁷/polishing time (= 5/60 hours).

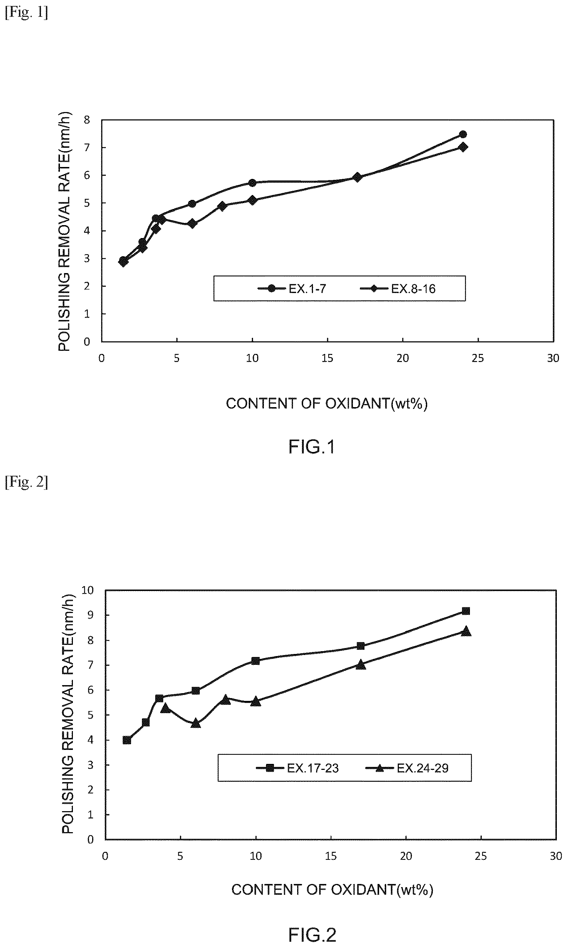

The obtained polishing removal rate was shown in the corresponding column in Table 1. The relation between the polishing removal rate of each example and the content of the oxidant in the polishing composition is shown in Fig. 1. In Fig. 1, a horizontal axis represents the content of the oxidant (unit: wt%) and a vertical axis represents the polishing removal rate (unit: nm/h).

### (AFM scratch evaluation)

The SiC wafer was polished with the polishing composition according to each example under the aforementioned polishing conditions, and then the surface of the polished SiC wafer was observed with an atomic force microscope (AFM) under the following conditions to check the presence or absence of a dent. The dent herein referred to means a depression defect with a depth of 1 nm or more and 100 nm or less, and the entire defect can be observed in a visual field of 10 µm on each side (that is, with a length of about several micrometers). The surface without any observed dents is evaluated to be excellent, which is expressed by A, and the surface with the observed dent is evaluated to be defective, which is expressed by B, and the results are shown in the corresponding columns in Table 1.
Evaluation machine: atomic force microscope available from Bruker corporation, model "nanoscope V"
Viewing angle: 10 µm × 10 µm
Scanning speed: 1 Hz (20 µm/sec)
Scanning density: 256 × 256
Measurement point: one point at center of wafer

**[Table 1]**

| Table 1 | | | | | | | | |
|---|---|---|---|---|---|---|---|---|
| | Abrasive | | Oxidant | | pH adjuster | pH | Polishing removal rate (nm/h) | AFM scratch |
| | Content of silica (wt%) | Content of alumina (wt%) | Kind | Content (wt%) | | | | |
| Example 1 | 0.1 | 0 | NaMnO₄ | 1.4 | HNO₃ | 3.0 | 2.94 | A |
| Example 2 | 0.1 | 0 | NaMnO₄ | 2.7 | HNO₃ | 3.0 | 3.60 | A |
| Example 3 | 0.1 | 0 | NaMnO₄ | 3.6 | HNO₃ | 3.0 | 4.45 | A |
| Example 4 | 0.1 | 0 | NaMnO₄ | 6.0 | HNO₃ | 3.0 | 4.97 | A |
| Example 5 | 0.1 | 0 | NaMnO₄ | 10.0 | HNO₃ | 3.0 | 5.72 | A |
| Example 6 | 0.1 | 0 | NaMnO₄ | 17.0 | HNO₃ | 3.0 | 5.92 | A |
| Example 7 | 0.1 | 0 | NaMnO₄ | 24.0 | HNO₃ | 3.0 | 7.48 | A |
| Example 8 | 0 | 1.0 | NaMnO₄ | 1.4 | HNO₃ | 3.0 | 2.88 | B |
| Example 9 | 0 | 1.0 | NaMnO₄ | 2.7 | HNO₃ | 3.0 | 3.39 | B |
| Example 10 | 0 | 1.0 | NaMnO₄ | 3.6 | HNO₃ | 3.0 | 4.07 | B |
| Example 11 | 0 | 1.0 | NaMnO₄ | 4.0 | HNO₃ | 3.0 | 4.40 | B |
| Example 12 | 0 | 1.0 | NaMnO₄ | 6.0 | HNO₃ | 3.0 | 4.27 | B |
| Example 13 | 0 | 1.0 | NaMnO₄ | 8.0 | HNO₃ | 3.0 | 4.88 | B |
| Example 14 | 0 | 1.0 | NaMnO₄ | 10.0 | HNO₃ | 3.0 | 5.10 | B |
| Example 15 | 0 | 1.0 | NaMnO₄ | 17.0 | HNO₃ | 3.0 | 5.93 | B |
| Example 16 | 0 | 1.0 | NaMnO₄ | 24.0 | HNO₃ | 3.0 | 7.02 | B |

As is clear from the results shown in Table 1, it has been confirmed that the generation of a scratch was suppressed with the polishing compositions according to Example 1 to Example 7 containing 0.1 wt% of the silica abrasive, compared to the polishing compositions according to Example 8 to Example 16 containing the alumina abrasive. In addition, as is clear from the results shown in Table 1 and Fig. 1, it has been confirmed that using sodium permanganate as the oxidant tends to improve the polishing removal rate.

### «Experimental Example 2»

### <Preparation of polishing composition>

### (Example 17)

A silica abrasive, sodium permanganate as the oxidant, calcium nitrate, aluminum nitrate, and deionized water were mixed to prepare a polishing composition containing the silica abrasive at a concentration of 0.1%, sodium permanganate at a concentration of 1.4%, calcium nitrate (calculated based on Ca) at a concentration of 10 mM (that is, 10 mmol/L), and aluminum nitrate (calculated based on Al) at a concentration of 30 mM (that is, 30 mmol/L). The pH of the polishing composition in this example was 3.3. As the silica abrasive, colloidal silica with an average primary particle diameter of 35 nm was used.

### (Example 18 to Example 23)

Polishing compositions according to these examples were prepared in a manner similar to Example 17 except that the concentration of sodium permanganate was set as shown in Table 2. The pH of the polishing composition in each example was as shown in Table 2.

### (Example 24)

An alumina abrasive, sodium permanganate as the oxidant, aluminum nitrate, and deionized water were mixed to prepare a polishing composition containing the alumina abrasive at a concentration of 1.0%, sodium permanganate at a concentration of 4.0%, and aluminum nitrate (calculated based on Al) at a concentration of 20 mM. The pH of the polishing composition in this example was 3.5. As the alumina abrasive, an α-alumina abrasive with an average primary particle diameter of 310 nm was used.

### (Example 25 to Example 29)

Polishing compositions according to these examples were prepared in a manner similar to Example 24 except that the concentration of sodium permanganate was set as shown in Table 2. The pH of the polishing composition in each example was as shown in Table 2.

### <Polishing of object to be polished>

A SiC wafer was preliminarily polished using a preliminary polishing composition containing an alumina abrasive. The preliminarily polished SiC wafer was set as the object to be polished, and the object to be polished was polished under the same polishing conditions as those in Experimental Example 1 using directly each polishing composition according to the corresponding example as the polishing slurry.

### <Measurement and evaluation>

### (Polishing removal rate)

The polishing removal rate was calculated in accordance with a method similar to that in Experimental Example 1. The obtained polishing removal rate was shown in the corresponding column in Table 2. The relation between the polishing removal rate of each example and the content of the oxidant in the polishing composition is shown in Fig. 2. In Fig. 2, a horizontal axis represents the content of the oxidant (unit: wt%) and a vertical axis represents the polishing removal rate (unit: nm/h).

### (AFM scratch evaluation)

The presence or absence of the dent was checked in accordance with a method similar to that in Experimental Example 1. The evaluation results were shown in the corresponding columns in Table 2.

### [Table 2]

**Table 2**

| | Abrasive | | Oxidant | | First metal salt | Second metal salt | pH | Polishing removal rate (nm/h) | AFM scratch |
|---|---|---|---|---|---|---|---|---|---|
| | Content of silica (wt%) | Content of alumina (wt%) | Kind | Content (wt%) | Calcium nitrate (mM) | Aluminum nitrate (mM) | | | |
| Example 17 | 0.1 | 0 | NaMnO₄ | 1.4 | 10 | 30 | 3.3 | 3.99 | A |
| Example 18 | 0.1 | 0 | NaMnO₄ | 2.7 | 10 | 30 | 3.2 | 4.70 | A |
| Example 19 | 0.1 | 0 | NaMnO₄ | 3.6 | 10 | 30 | 3.3 | 5.66 | A |
| Example 20 | 0.1 | 0 | NaMnO₄ | 6.0 | 10 | 30 | 3.3 | 5.98 | A |
| Example 21 | 0.1 | 0 | NaMnO₄ | 10.0 | 10 | 30 | 3.2 | 7.17 | A |
| Example 22 | 0.1 | 0 | NaMnO₄ | 17.0 | 10 | 30 | 3.0 | 7.78 | A |
| Example 23 | 0.1 | 0 | NaMnO₄ | 24.0 | 10 | 30 | 2.8 | 9.17 | A |
| Example 24 | 0 | 1.0 | NaMnO₄ | 4.0 | 0 | 20 | 3.5 | 5.30 | B |
| Example 25 | 0 | 1.0 | NaMnO₄ | 6.0 | 0 | 20 | 3.5 | 4.69 | B |
| Example 26 | 0 | 1.0 | NaMnO₄ | 8.0 | 0 | 20 | 3.5 | 5.64 | B |
| Example 27 | 0 | 1.0 | NaMnO₄ | 10.0 | 0 | 20 | 3.6 | 5.57 | B |
| Example 28 | 0 | 1.0 | NaMnO₄ | 17.0 | 0 | 20 | 3.7 | 7.04 | B |
| Example 29 | 0 | 1.0 | NaMnO₄ | 24.0 | 0 | 20 | 3.7 | 8.38 | B |

As is clear from the results shown in Table 2, it has been confirmed that the generation of a scratch was suppressed with the polishing compositions according to Example 17 to Example 23 containing 0.1 wt% of the silica abrasive, compared to the polishing compositions according to Example 24 to Example 29 containing the alumina abrasive. In addition, as is clear from the results shown in Table 2 and Fig. 2, it has been confirmed that using sodium permanganate as the oxidant tends to improve the polishing removal rate. Furthermore, it has been confirmed that using calcium nitrate as the first metal salt and aluminum nitrate as the second metal salt in addition to using sodium permanganate tends to improve the polishing removal rate more.

While specific examples of the present invention have been described above in detail, these are only illustrative, and do not limit the scope of the claims. The technologies recited in the claims include various modifications and alternations of the specific examples illustrated above.

## Claims

1. A polishing composition comprising sodium permanganate as an oxidant, wherein an abrasive A with a Mohs hardness of less than 8 is contained as an abrasive or the abrasive is not contained.

2. The polishing composition according to claim 1, wherein the polishing composition contains the abrasive A, and a content of the abrasive A is less than 10 wt%.

3. The polishing composition according to claim 1 or 2, wherein the polishing composition contains the abrasive A, and a silica abrasive is contained as the abrasive A.

4. The polishing composition according to any one of claims 1 to 3, further comprising a first metal salt selected from alkaline earth metal salts.

5. The polishing composition according to claim 4, wherein the first metal salt is a nitrate.

6. The polishing composition according to any one of claims 1 to 5, further comprising a second metal salt selected from salts of cations containing metals that belong to Groups 3 to 16 in the periodic table, and anions.

7. The polishing composition according to claim 6, wherein the second metal salt is an aluminum salt.

8. The polishing composition according to any one of claims 1 to 7, wherein a pH is 1.0 or more and less than 6.0.

9. The polishing composition according to any one of claims 1 to 8, in use for polishing a material having a Vickers hardness of 1500 Hv or more.

10. The polishing composition according to any one of claims 1 to 9, in use for polishing silicon carbide.

11. A polishing method comprising a step of polishing an object to be polished using the polishing composition according to any one of claims 1 to 10.
